(19) Europäisches Patentamt
European Patent Office
Office européen des brevets

(11) **EP 1 924 931 B1**

(12) **EUROPÄISCHE PATENTSCHRIFT**

(45) Veröffentlichungstag und Bekanntmachung des Hinweises auf die Patenterteilung:
**12.06.2019 Patentblatt 2019/24**

(51) Int Cl.:
***G06F 17/10*** *(2006.01)*     ***H03M 7/30*** *(2006.01)*

(21) Anmeldenummer: **06792795.4**

(22) Anmeldetag: **11.08.2006**

(86) Internationale Anmeldenummer:
**PCT/EP2006/065263**

(87) Internationale Veröffentlichungsnummer:
**WO 2007/031380 (22.03.2007 Gazette 2007/12)**

(54) **VERFAHREN ZUR SPEICHEREFFIZIENTEN DURCHFÜHRUNG EINER BURROWS-WHEELER-RÜCKTRANSFORMATION**

METHOD FOR CARRYING OUT AN INVERSE BURROWS-WHEELER TRANSFORM WITH EFFICIENT MEMORY USE

PROCEDE POUR L'EXECUTION EFFICACE EN TERME DE MEMOIRE D'UNE TRANSFORMEE INVERSE DE BURROWS-WHEELER

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **15.09.2005 DE 102005044145**

(43) Veröffentlichungstag der Anmeldung:
**28.05.2008 Patentblatt 2008/22**

(73) Patentinhaber: **Siemens Aktiengesellschaft
80333 München (DE)**

(72) Erfinder:
• **LAUTHER, Ulrich
80686 München (DE)**
• **LUKOVSZKI, Tamas
1148 Budapest (HU)**

(56) Entgegenhaltungen:
• **LAUTHER U ET AL: "Space efficient algorithms for the Burrows-Wheeler backtransformation" ALGORITHMS - ESA 2005, 13TH ANNUAL EUROPEAN SYMPOSIUM ON ALGORITHMS, OCTOBER 3-6, 2005, PALMA DE MALLORCA, SPAIN, LECTURE NOTES IN COMPUTER SCIENCE VOL. 3669, Oktober 2005 (2005-10), Seiten 293-304, XP019020505 ISBN: 3-540-29118-0**
• **SEWARD J: "Space-time tradeoffs in the Inverse B-W Transform" PROCEEDINGS OF THE 2001 DATA COMPRESSION CONFERENCE (DCC 2001), MARCH 27-29, 2001, SNOWBIRD, UTAH, USA, März 2001 (2001-03), Seiten 439-448, XP002472179 IEEE ISBN: 0-7695-1031-0**
• **BURROWS M ET AL: "A block-sorting lossless data compression algorithm" SRC RESEARCH REPORT, Bd. 124, 10. Mai 1994 (1994-05-10), XP003013634 in der Anmeldung erwähnt**

**Beschreibung**

Die Erfindung betrifft ein Verfahren zur speichereffizienten Durchführung einer Burrows-Wheeler-Rücktransformation, bei der ein String oder Eingabe-String mit einer vorbestimmten String-Länge, der mittels einer Burrows-Wheeler-Transformation transformiert worden ist, rücktransformiert wird.

Die vorliegende Erfindung betrifft das Gebiet der Burrows-Wheeler-Transformation (BWT) und insbesondere die inverse Burrows-Wheeler-Transformation. Die Burrows-Wheeler-Transformation ist ein bekanntes Transformationsverfahren, welches vor allem für solche Anwendungen eingesetzt wird, bei denen hohe Datenraten verarbeitet werden. Diese wird beispielsweise in sehr effektiven Kompressionsverfahren, z.B. in dem bekannten Computerprogramm bzip2 eingesetzt. Die Kompression erfolgt blockweise, wobei insbesondere mit sehr großen Blöcken gearbeitet wird, um eine möglichst hohe Kompressionsrate zu erzielen. So werden beispielsweise bei dem Computerprogramm bzip2 standardmäßig Blöcke von 900.000 Bytes, im Niedrigspeichermodus immer noch 100.000 Bytes verwendet. Bei der Burrows-Wheeler-Rücktransformation muss die Dekomprimiereinheit oder der Dekompressor bei herkömmlichen Verfahren für jedes Eingabe-Zeichen oder Eingabe-Symbol vier Bytes an Hilfsspeicher, z.B. RAM-Speicher, bereitzustellen.

Ein Problem bei der BWT-Transformation und BWT-Rücktransformation besteht darin, dass sie nur dann eingesetzt werden können, wenn genügend große Speicherressourcen zur Verfügung gestellt werden können. Das Vorsehen von großen Speicherressourcen, insbesondere im Mobilfunk und in der Automobiltechnik, bedeutet für den jeweiligen Hersteller einen hohen und oft auch zu hohen Kostenaufwand, so dass weniger speicherintensive Komprimierverfahren, wie beispielsweise die Huffman-Kodierung, bei einem vorbestimmten Speicherplatz der Dekomprimiereinheit eingesetzt werden. Außerdem benötigen große Speicherressourcen auch einen entsprechend großen Platzbedarf.

Zur weiteren Erläuterung der allgemeinen Problematik soll im Folgenden eine kurze Einführung in die BWT-Rücktransformation gegeben werden. Diese kurze Einführung wird nur auf die für die vorliegende Erfindung wesentlichen Aspekte der BWT-Rücktransformation eingehen. Eine ausführliche Dokumentation der BWT-Transformation und -Rücktransformation findet sich in Burrows, M. und Wheeler, D.J.: A block-sorting lossless data compression algorithm, SRC Research Report, 1994(http:// gatekeeper.resarch.compaq.com/pub/DEC/SRC/researchreports/Abstracts/src-rr-124.html).

Desweiteren offenbart das Dokument SEWARD J: "Space-time tradeoffs in the Inverse B-W Transform",PROCEEDINGS OF THE 2001 DATA COMPRESSION CONFERENCE (DCC 2001), MARCH 27-29, 2001, SNOWBIRD, UTAH, USA, März 2001 (2001-03), Seiten 439-448, XP002472179,IEEE ISBN: 0-7695-1031-0 verschiedene vorteilhafte Implementierungen für die Burrows-Wheeler-Rücktransformation bezüglich Speicherressourcen und Geschwindigkeit.

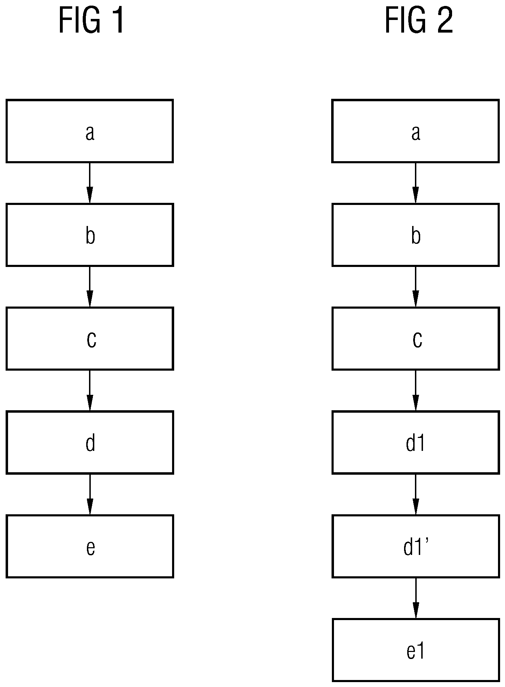

Konzeptionell wird bei der BWT-Rücktransformation derart vorgegangen, dass der Eingabe-String aus n Zeichen oder Symbolen zunächst n-fach dupliziert wird, so dass eine nxn-Matrix entsteht. Dabei werden die Zeichen in der Zeile i der nxn-Matrix um i Positionen zyklisch verschoben. Daraufhin werden die Zeilen der Matrix lexografisch nach ihrem Inhalt sortiert und die letzte Spalte, welche im Folgenden mit L bezeichnet wird, wird als Ergebnis zusammen mit dem sogenannten "Primary Index" abgespeichert. Der "Primary Index" gibt an, in welcher Zeile der Matrix nach deren Sortierung das Original des Eingabe-Strings vorliegt. Für die Rücktransformation wird dann außer L selbst noch die erste Spalte, welche im Folgenden mit F bezeichnet wird, verwendet. Die erste Spalte F kann aber aus der letzten Spalte L durch Sortierung der enthaltenen Zeichen oder Symbole abgeleitet werden. Unten stehende Abbildung 1 zeigt die letzte Spalte L und die erste Spalte F für den Eingabe-String "CARINA". Der Pfeil zeigt den "Primary Index".

Abbildung 1:

| | | L rank | F | base |
|---|---|---|---|---|
| | 0 | $N_0$ | $A_0$ | A:0 |
| | 1 | $C_o$ | $A_1$ | C:2 |
| → | 2 | $A_0$ | $C_0$ | 1:3 |
| | 3 | $R_0$ | $I_0$ | N:4 |
| | 4 | $I_0$ | $N_0$ | R:5 |
| | 5 | $A_1$ | $R_0$ | |

In beiden Spalten (F, L) wurden die Instanzen jedes Zeichens beginnend mit 0 nummeriert. So enthält die erste Zeile der Spalte F das 0-te "A", wobei Zeile 5 der Spalte L die Instanz 1 von "A" enthält. Diese Indices bezeichnen den Rang des Zeichens oder Symbols an der jeweiligen Position in der Spalte.

Um den ursprünglichen Eingabe-String "CARINA" zu rekonstruieren, wird mit dem "Primary Index" gestartet und das entsprechende Zeichen oder Symbol aus der L-Spalte, hier "A", ausgegeben. Daraufhin wird $A_0$ in der F-Spalte gesucht. Im vorliegenden Beispiel wird es in Zeile 0 gefunden und demnach wird das Symbol "N" ausgegeben. Im Folgenden wird nach demselben Schema verfahren und es werden weiterhin die Symbole "I", "R", "A" und schließlich "C" erhalten, so dass der Eingabe-String "CARINA" in umgekehrter Reihenfolge dargestellt ist. Die Position der F-Spalte kann für eine Zeichen-Rang-Kombination auf einfache Weise gefunden werden, wenn für jedes Zeichen oder Symbol des Alphabets die Position des ersten Auftretens in der F-Spalte gespeichert wird. Diese Werte sind in der Abbildung 1 und im Folgenden mit "base" bezeichnet.

Somit wird ein einfaches Verfahren zur Rücktransformation (siehe Quellcode 1) erhalten, wenn die Vektoren "base" und "rank" bekannt sind.

Quellcode 1:

```
int h = primary_index;
for (int i = 0; i < n; i++) {
    char c = L[h];
    output (c);
    h = base[c] + rank(h);
}
```

Die Vektoren "base" und "rank" können je mit einem Durchlaufen von L und einem weiteren Durchlaufen sämtlicher Zeichen oder Symbole des Alphabets berechnet werden (siehe Quellcode 2). Für das vorliegende Beispiel wurde ein Alphabet von 256 Zeichen gewählt.

Quellcode 2:

```
for (int i = 0; i < 256; i++) base[i] = 0;
for (int i = 0; i < n; i++) {
    char c = L[i];
    rank [i] = base[c];
    base[c]++;
}
int total = 0;
for (int i = 0; i < 256; i++) {
    int h = base[i];
    base[i] = total;
    total += h;
}
```

Das oben stehende Verfahren zur BWT-Rücktransformation benötigt $O(n)$ Speicherplatz, d.h. n Wörter für den Rank-Vektor, und $O(n)$ Zeiteinheiten. Dieser Speicherplatzbedarf von 4 • n Bytes an Hilfsspeicher für jedes Eingabesymbol ist - wie oben ausgeführt - bei vielen Embedded-Systems prohibitiv.

Die Aufgabe der vorliegenden Erfindung besteht daher darin, den Speicherplatzbedarf bei einer Burrows-Wheeler-Rücktransformation zu reduzieren.

Eine weitere Aufgabe besteht darin, das Verhältnis zwischen Speicherplatzbedarf und insbesondere Rechenzeit bei einer Burrows-Wheeler-Rücktransformation zu optimieren.

Erfindungsgemäß wird zumindest eine dieser gestellten Aufgaben durch ein Verfahren mit den Merkmalen des Patentanspruchs 1 gelöst.

Somit ist erfindungsgemäß ein Verfahren zur speichereffizienten Durchführung einer Burrows-Wheeler-Rücktransformation vorgesehen, bei der ein String S mit einer vorbestimmten Stringlänge n rücktransformiert wird, der eine Vielzahl von Symbolen x eines vorbestimmten Alphabets A aufweist, wobei ein Rang rank(i) zu einer Position i des Strings S, $0 \leq i < n$, die Häufigkeit des an der Position i stehenden Symbols x in einem Teil-String S[0,...,i] des Strings S angibt, wobei das erfindungsgemäße Verfahren die folgenden Schritte aufweist:

(a) Unterteilen des Strings S in eine Anzahl n' von Blöcken B mit einer vorbestimmten Blockgröße L, wobei jeweils der j-te Block B[j], $0 \leq j \leq n'$, an der Position j • L beginnt;
(b) Bestimmen jeweils eines Häufigkeitsparameters b[j,x] für jedes Symbol x und jeden Block B[j], wobei der jeweilige Häufigkeitsparameter b[j,x] die Häufigkeit des an der entsprechenden Position i stehenden Symbols x bis zum entsprechenden j-ten Block B[j] angibt;

(c) Abspeichern des jeweiligen bestimmten Häufigkeitsparameters b[j,x];

(d) Ermitteln jeweils eines relativen Ranges r[i] zu jeder Position (i) des Strings S, wobei der relative Rang r[i] die Häufigkeit des an der jeweiligen Position i stehenden Symbols x ausschließlich in dem entsprechenden j-ten Block B[j], der die entsprechende Position i beinhaltet, angibt; und

(e) Ermitteln des jeweiligen, für die Burrows-Wheeler-Rücktransformation benötigten Ranges rank(i) an der Position i mittels des entsprechenden ermittelten relativen Ranges r[i] und des entsprechenden abgespeicherten Häufigkeitsparameters b[j,x].

Die der Erfindung zugrunde liegende Idee besteht darin, einen Vektor oder Rangvektor, bestehend aus den n Rängen für die n Positionen i des Strings S, der herkömmlicherweise bei oder vor der Burrows-Wheeler-Rücktransformation berechnet und abgespeichert wird, als solches nicht abzuspeichern, sondern den jeweils benötigten Rang mittels des relativen Ranges und des entsprechen Häufigkeitsparameters bereitzustellen. Dadurch wird weniger Speicherplatzbedarf benötigt. Dadurch dass nun weniger Speicherplatz für die Burrows-Wheeler-Rücktransformation benötigt wird, kann diese auch bei Embedded-Systems mit begrenzten Speicherressourcen kostengünstig eingesetzt werden.

In den Unteransprüchen finden sich vorteilhafte Ausgestaltungen und Weiterbildungen des in Anspruch 1 angegebenen Verfahrens zur speichereffizienten Durchführung einer Burrows-Wheeler-Rücktransformation.

Gemäß einer bevorzugten Ausgestaltung der Erfindung wird die Anzahl n' der Blöcke B[j] mittels der Formel

$$\text{n}' = \left\lceil \frac{n}{L} \right\rceil$$ berechnet.

Gemäß einer weiteren bevorzugten Ausgestaltung weist jedes Symbol x des vorbestimmten Alphabets A eine vorbestimmte Symbollänge auf.

Gemäß einer weiteren bevorzugten Ausgestaltung wird der jeweilige, gemäß Verfahrensschritt (e) für die Burrows-Wheeler-Rücktransformation benötigte Rang rank(i) an der Position i mittels der Formel $rank[i]=b[i/L-1,x]+r[i]$ berechnet.

Gemäß einer bevorzugten Weiterbildung des erfindungsgemäßen Verfahrens werden die Verfahrensschritte (d) und (e) mittels folgender Verfahrensteilschritte durchgeführt:

(d1) Berechnen jeweils des relativen Ranges r[i] zu jeder Position (i) des Strings S aus dem Rang rank(i) des Symbols x an der entsprechenden Position (i) und dem entsprechenden abgespeicherten Häufigkeitsparameter b[j,x] für das Symbol x und den entsprechenden j-ten Block B[j], wobei der relative Rang r[i] die Häufigkeit des an der jeweiligen Position i stehenden Symbols x ausschließlich in dem entsprechenden j-ten Block B[j], der die entsprechende Position i beinhaltet, angibt;

(d1') Abspeichern des jeweiligen berechneten relativen Ranges r[i]; und

(e1) Ermitteln des jeweiligen, für die Burrows-Wheeler-Rücktransformation benötigten Ranges rank(i) an der Position i mittels des entsprechenden abgespeicherten relativen Ranges r[i] und des entsprechenden abgespeicherten Häufigkeitsparameters b[j,x].

Gemäß einer weiteren bevorzugten Ausgestaltung wird der Rang rank[i] für die Berechnung des relativen Ranges r[i] mittels eines ersten Zählers, der die Häufigkeit des Symbols x an der entsprechenden Position i in dem Teil-String S[0,...,i] zählt, ermittelt.

Eine weitere bevorzugte Ausgestaltung des erfindungsgemäßen Verfahrens ist dadurch gekennzeichnet, dass der relative Rang r[i] mittels der Formel

$$r[i] = \begin{cases} rank\ [i] - b[i / L - 1, x] & wenn & i \bmod L < L / 2 \\ b[i / L, x] - rank\ [i] - 1 & sonst \end{cases}$$

berechet wird.

Gemäß einer weiteren bevorzugten Weiterbildung werden die Verfahrensschritte (d) und (e) mittels folgender Verfahrensteilschritte durchgeführt:

(d2) Ermitteln des relative Ranges r[i] mittels eines zweiten Zählers, der die Häufigkeit des Symbols x an der entsprechenden Position i ausschließlich in dem entsprechenden j-ten Block B[j] zählt; und

(e2) Ermitteln des jeweiligen, für die Burrows-Wheeler-Rücktransformation benötigten Ranges rank(i) an der Position i mittels des entsprechenden ermittelten relativen Ranges r[i] und des entsprechenden abgespeicherten Häufigkeitsparameters b[j,x].

Gemäß einer weiteren bevorzugten Ausgestaltung beginnt der zweite Zähler zur Ermittlung des relative Ranges r[i] an einer ersten Zählposition j • L, falls sich die entsprechende Position i in einer ersten Blockhälfte B[j • L,...,j • L+L/2-1] befindet, oder an einer zweiten Zählposition (j+1) • L, falls sich die entsprechende Position i in einer zweiten Blockhälfte B[j·L+L/2,...,(j+1)·L-1] befindet, zu zählen.

Gemäß einer weiteren bevorzugten Ausgestaltung wird der jeweilige, für die Burrows-Wheeler-Rücktransformation benötigte Rang rank(i) an der Position i mittels der Formel

$$rank[i] = \begin{cases} b[i / L, x] + r[i] & falls \quad i \bmod L < L / 2 \\ b[i / L + 1, x] - r[i] - 1 & sonst \end{cases}$$

berechnet.

Die Erfindung wird nachfolgend anhand der in den schematischen Figuren der Zeichnung angegebenen Ausführungsbeispielen näher erläutert. Es zeigen:

Figur 1    ein schematisches Ablaufdiagramm eines ersten Ausführungsbeispiels des erfindungsgemäßen Verfahrens;

Figur 2    ein schematisches Ablaufdiagramm eines zweiten Ausführungsbeispiels des erfindungsgemäßen Verfahrens; und

Figur 3    ein schematisches Ablaufdiagramm eines dritten Ausführungsbeispiels des erfindungsgemäßen Verfahrens.

In allen Figuren sind gleiche bzw. funktionsgleiche Verfahrensschritte - sofern nichts Anderes angegeben ist - mit denselben Bezugszeichen versehen worden.

In Figur 1 ist ein schematisches Ablaufdiagramm eines ersten Ausführungsbeispiels des erfindungsgemäßen Verfahrens zur speichereffizienten Durchführung einer Burrows-Wheeler-Rücktransformation dargestellt, bei der ein String S mit einer vorbestimmten String-Länge n rücktransformiert wird, der eine Vielzahl von Symbolen x eines vorbestimmten Alphabets A aufweist, wobei ein Rang rank (i) zu einer Position i des Strings S, $0 \le i < n$, die Häufigkeit des an der Position i stehenden Symbols x in einem Teil-String S[0, ..., i] des Strings S angibt. Nachfolgend wird das erste Ausführungsbeispiel des erfindungsgemäßen Verfahrens anhand des Blockschaltbildes in Figur 1 erläutert. Das erfindungsgemäße Verfahren weist demnach folgende Verfahrensschritte auf:

Verfahrensschritt (a):

Der String S wird in eine Anzahl n' von Blöcken B mit einer vorbestimmten Blockgröße L unterteilt, wobei jeweils der j-ten Block B[j], $0 \le j < n'$, an der Position j·L beginnt. Vorzugsweise wird die Anzahl n' der Blöcke B[j] mittels der

Formel $n' = \left\lceil \dfrac{n}{L} \right\rceil$ berechnet. Insbesondere besteht jeder Block B[j] aus $L = 2^l$ aufeinander folgenden Symbolen x, wobei jeweils ein Symbol x beispielsweise eine Symbollänge von einem Byte aufweist. Der letzte Block kann auch weniger als L Symbole aufweisen. Vorzugsweise weist jedes Symbol x des vorbestimmten Alphabetes A eine vorbestimmte Symbollänge auf. Im Folgenden wird w als die Länge eines Wortes in Bytes bezeichnet. Benutzt man beispielsweise 32 Bit-Wörter, so beträgt w = 32/8 = 4 Bytes.

Verfahrensschritt (b):

Für jedes Symbol x und für jeden Block B[j] wird ein Häufigkeitsparameter b[j,x] bestimmt, wobei der jeweilige Häufigkeitsparameter b[j,x] die Häufigkeit des an der entsprechenden Position i des Strings S stehenden Symbols x bis zum entsprechenden j-ten Block B[j] angibt.

Verfahrensschritt (c):

Der jeweilige bestimmte Häufigkeitsparameter b[j,x] wird beispielsweise in einem RAM-Speicher abgespeichert. Zum Speichern aller Häufigkeitsparameter b[j,x], $0 \le j < n'$, werden n'/A/ = ⌈n/L⌉ /A/ Computerwörter, d. h. ⌈n/L⌉8w/A/

Bits benötigt. Beispielsweise ergibt sich ein Speicherplatzbedarf bei einer Blocklänge L von 8192 Bytes, einem Alphabet von 256 Zeichen (/A/ = 256) und w = 4 (32 Bit-Wörter) ein Speicherplatzbedarf von $4 \cdot 256 \cdot \dfrac{n}{8192}$ Bytes, also $n \cdot \dfrac{1}{8}$ Bytes.

Verfahrensschritt (d):

Zu jeder Position i des Strings S wird ein relativer Rang r[i] ermittelt. Der relative Rang r[i] gibt die Häufigkeit des an der jeweiligen Position i stehenden Symbols x ausschließlich in dem entsprechenden j-ten Block B[j], der die entsprechende Position i beinhaltet, an.

Verfahrensschritt (e):

Es wird der jeweilige, für die Burrows-Wheeler-Rücktransformation benötigte Rang rank(i) an der Position i mittels des entsprechenden ermittelten relativen Ranges r[i] und des entsprechenden gespeicherten Häufigkeitsparameters b[j,x] ermittelt. Vorzugsweise wird der jeweilige benötigte Rang rank (i) an der Position i mittels der Formel *rank*[*i*]=*b*[*i*/*L*-1,*x*]+*r*[*i*] berechnet. Nachdem 0 ≤ r[i] < L ist, sind für die Abspeicherung eines einzelnen relativen Ranges r[i] l Bits vorzusehen ($2^l$ = L). Somit werden n·l Bits für die Abspeicherung aller n Werte des relativen Ranges r[i] benötigt.

Figur 2 zeigt ein schematisches Ablaufdiagramm eines zweiten Ausführungsbeispiels des erfindungsgemäßen Verfahrens. Das erfindungsgemäße Verfahren nach dem zweiten Ausführungsbeispiel unterscheidet sich von dem ersten Ausführungsbeispiel gemäß Figur 1 dahingehend, dass die Verfahrensschritte (d) und (e) mittels folgender Verfahrensteilschritte (d1), (d1') und (e1) durchgeführt werden:

Verfahrensschritt (d1):

Zu jeder Position i des Strings S wird jeweils der relative Rang r[i] aus dem Rang rank(i) des Symbols x an der entsprechenden Position i und dem entsprechenden abgespeicherten Häufigkeitsparameter b[j,x] für das Symbol x und den entsprechenden j-ten Block B[j] berechnet, wobei der relative Rang r[i] die Häufigkeit des an der jeweiligen Position i stehenden Symbols x ausschließlich in dem entsprechenden j-ten Block B[j], der die entsprechende Position i beinhaltet, angibt. Vorzugsweise wird der Rang rank(i) für die Berechnung des relativen Ranges r[i] mittels eines ersten Zähler, der die Häufigkeit des Symbols x an der entsprechenden Position i in dem Teilstring S[0,...,i] zählt, ermittelt. Insbesondere wird der relative Rang r[i] mittels der Formel

$$r[i] = \begin{cases} rank\,[i] - b[i/L - 1, x] & wenn \quad i \bmod L < L/2 \\ b[i/L, x] - rank\,[i] - 1 & sonst \end{cases}$$

berechnet. Unter Verwendung oben stehender Formel wird für die Abspeicherung aller Werte des relativen Ranges r[i] nur ein Speicherplatz von n·(l-1) Bits verwendet, da jeder Wert für einen relativen Rang r[i] mit $\dfrac{L}{2}$ darstellbar ist

$$(\mathtt{l} \cdot \mathtt{ld}\,(\mathtt{L}/2) = \mathtt{l} \cdot (\mathtt{l} - 1))\,.$$

Verfahrensschritt (d1'):

Der jeweilige berechnete relative Rang r[i] wird abgespeichert. Insbesondere wird der jeweilige berechnete Rang r[i] in einem RAM-Speicher abgespeichert.

Verfahrensschritt (el):

Es wird der jeweilige, für die Burrows-Wheeler-Rücktransformation benötigte Rang rank(i) an der Position i mittels des entsprechenden abgespeicherten relativen Ranges r[i] und des entsprechenden abgespeicherten Häufigkeitsparameters b[j,x] ermittelt. Insbesondere wird der jeweilige, für die Burrows-Wheeler-Rücktransformation benötigte Rang rank(i) an der Position i mittels der Formel

$$r[i] = \begin{cases} rank\,[i] - b[i\,/\,L-1,x] & wenn \quad i \bmod L < L\,/\,2 \\ b[i\,/\,L,x] - rank\,[i] - 1 & sonst \end{cases}$$

berechnet.

Oben stehende Summe kann unter Verwendung von höchstens zwei Speicherzugriffen und einer konstanten Anzahl von Prozessorzyklen berechnet werden.

Die Speicheranforderung zum Speichern aller Werte des relativen Ranges r[i] und des Häufigkeitsparameters

$$n\left(l-1+\frac{8w/A/}{L}\right) = n\left(l-1+8w/A/2^{-l}\right)$$

b[j,x], $0 \le i < n$, $0 \le j < n'$, $x \in A$ beträgt                     Bits. Das Minimum dieses Ausdruckes wird an dem Punkt erhalten, dessen Ableitung Null ist.

Somit ergibt sich:

$$1 + 8w/A/2^{-l}\,(-\ln 2) = 0$$

$$2^{-l} = \frac{1}{8w/A/\ln 2}$$

$$l = \log(8w/A/) + \log \ln 2$$

Mit /A/ = 256 und w = 4 (32 Bit-Wörter) ergibt sich das kontinuierliche Minimum für l ≈ 3 + 2 + 8 - 0.159. Setzt man also l = 12 oder l = 13 und die Blockgröße L = 4096 bzw. L = 8192 ergibt sich eine Größe der Datenstruktur von

$$\frac{13}{8} \cdot n$$

Bytes.

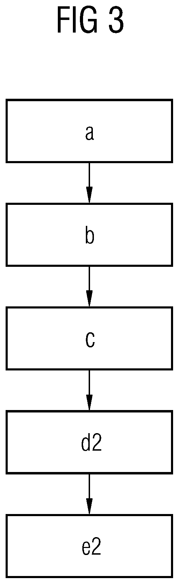

In Figur 3 ist ein schematisches Ablaufdiagramm eines dritten Ausführungsbeispiels des erfindungsgemäßen Verfahrens gezeigt. Das dritte Ausführungsbeispiel des erfindungsgemäßen Verfahrens unterscheidet sich von dem in Figur 1 dargestellten ersten Ausführungsbeispiel dahingehend, dass die Verfahrensschritte (d) und (e) mittels folgender Verfahrensteilschritte durchgeführt werden:

Verfahrensschritt (d2):

Der relative Rang r[i] wird mittels eines zweiten Zählers, der die Häufigkeit des Symbols x an der entsprechenden Position i ausschließlich in dem entsprechenden j-ten Block B[j] zählt, ermittelt. Vorzugweise beginnt der zweite Zähler an einer ersten Zählposition j • L, falls sich die entsprechende Position i in einer ersten Blockhälfte B[j·L,...,j·L+L/2-1] befindet, oder an einer zweiten Zählposition (j+1) • L, falls sich die entsprechende Position i in einer zweiten Blockhälfte B[j·L+L/2,...,(j+1)·L-1] befindet, zu zählen, um den entsprechenden relativen Rang r[i] zu ermitteln.

Verfahrensschritt (e2):

Es wird der jeweilige, für die Burrows-Wheeler-Rücktransformation benötigte Rang rank(i) an der Position i mittels des entsprechenden ermittelten relativen Ranges r[i] und des entsprechenden abgespeicherten Häufigkeitsparameters b[j,x] ermittelt. Vorzugsweise wird der jeweilige, für die Burrows-Wheeler-Rücktransformation benötigte Rank rank(i) an der Position i mittels der Formel

$$r[i] = \begin{cases} rank\,[i] - b[i\,/\,L-1,x] & wenn \quad i \bmod L < L\,/\,2 \\ b[i\,/\,L,x] - rank\,[i] - 1 & sonst \end{cases}$$

berechnet.

Obwohl die vorliegende Erfindung vorstehend anhand der bevorzugten Ausführungsbeispiele beschrieben wurde, ist sie darauf nicht beschränkt, sondern auf vielfältige Art und Weise modifizierbar.

**Patentansprüche**

1. Verfahren zur speichereffizienten Durchführung einer Burrows-Wheeler-Rücktransformation, bei der ein String S mit einer vorbestimmten Stringlänge n rücktransformiert wird, der eine Vielzahl von Symbolen x eines vorbestimmten Alphabets A aufweist, wobei ein Rang rank(i) an einer Position i, mit $0 \leq i < n$, des Strings S die Häufigkeit des an der Position i stehenden Symbols x in einem Teil-String S[0,...,i] des Strings S angibt, durch die folgenden Schritten gekennzeichnet:

    (a) Unterteilen des Strings S in eine Anzahl n' von Blöcken B mit einer vorbestimmten Blockgröße L, wobei jeweils der j-te Block B[j], mit $0 \leq j < n'$, an der Position j·L beginnt;
    (b) Bestimmen jeweils eines Häufigkeitsparameters b[j,x] für jedes Symbol x und jeden Block B[j], wobei der jeweilige Häufigkeitsparameter b[j,x] die Häufigkeit des an der entsprechenden Position i stehenden Symbols x bis zum entsprechenden j-ten Block B[j] angibt;
    (c) Abspeichern des jeweiligen bestimmten Häufigkeitsparameters b[j,x];
    (d) Ermitteln jeweils eines relativen Ranges r[i] zu jeder Position i des Strings S, wobei der relative Rang r[i] die Häufigkeit des an der jeweiligen Position i stehenden Symbols x ausschließlich in dem entsprechenden j-ten Block B[j], der die entsprechende Position i beinhaltet, bis zur Position i angibt; und
    (e) Ermitteln des jeweiligen, für die Burrows-Wheeler-Rücktransformation benötigten Ranges rank(i) an der Position i mittels des entsprechenden ermittelten relativen Ranges r[i] und des entsprechenden abgespeicherten Häufigkeitsparameters b[j,x].

2. Verfahren nach Anspruch 1,
    **dadurch gekennzeichnet,**

    **dass** sich die Anzahl n' der Blöcke B[j] aus der Beziehung $n' = \left\lceil \dfrac{n}{L} \right\rceil$ ergibt.

3. Verfahren nach einem oder mehreren der vorstehenden Ansprüche,
    **dadurch gekennzeichnet,**
    **dass** jedes Symbol x des vorbestimmten Alphabets A eine vorbestimmte Symbollänge aufweist.

4. Verfahren nach einem oder mehreren der vorstehenden Ansprüche,
    **dadurch gekennzeichnet,**
    **dass** sich der gemäß Verfahrensschritt (e) für die Burrows-Wheeler-Rücktransformation benötigte Rang rank(i) an der Position i aus der Beziehung $rank[i]=b[i/L\text{-}1,x]+r[i]$ ergibt.

5. Verfahren nach einem oder mehreren der Ansprüche 1 bis 3,
    **dadurch gekennzeichnet,**
    **dass** die Verfahrensschritte (d) und (e) mittels folgender Verfahrensteilschritte durchgeführt werden:

    (d1) Berechnen jeweils des relativen Ranges r[i] zu jeder Position (i) des Strings S aus dem Rang rank i des Symbols x an der entsprechenden Position i und dem entsprechenden abgespeicherten Häufigkeitsparameter b[j,x] für das Symbol x und den entsprechenden j-ten Block B[j], wobei der relative Rang r[i] die Häufigkeit des an der jeweiligen Position i stehenden Symbols x ausschließlich in dem entsprechenden j-ten Block B[j], der die entsprechende Position i beinhaltet, angibt;
    (d1') Abspeichern des jeweiligen berechneten relativen Ranges r[i]; und
    (e1) Ermitteln des jeweiligen, für die Burrows-Wheeler-Rücktransformation benötigten Ranges rank(i) an der Position i mittels des entsprechenden abgespeicherten relativen Ranges r[i] und des entsprechenden abgespeicherten Häufigkeitsparameters b[j,x].

6. Verfahren nach Anspruch 5,
    **dadurch gekennzeichnet,**
    **dass** der Rang rank(i) für die Berechnung des relativen Ranges r[i] mittels eines ersten Zählers, der die Häufigkeit des Symbols x an der entsprechenden Position i in dem Teil-String S[0,...,i] zählt, ermittelt wird.

7. Verfahren nach Anspruch 6,
    **dadurch gekennzeichnet,**

**dass** sich der relative Rang r[i] aus der Beziehung

$$r[i] = \begin{cases} rank\,[i] - b[i\,/\,L - 1, x] & wenn & i \bmod L < L\,/\,2 \\ b[i\,/\,L, x] - rank\,[i] - 1 & sonst \end{cases}$$

ergibt.

8. Verfahren nach einem oder mehreren der Ansprüche 1 bis 3,
   **dadurch gekennzeichnet,**
   **dass** die Verfahrensschritte (d) und (e) mittels folgender Verfahrensteilschritte durchgeführt werden:

   (d2) Ermitteln des relative Ranges r[i] mittels eines zweiten Zählers, der die Häufigkeit des Symbols x an der entsprechenden Position i ausschließlich in dem entsprechenden j-ten Block B[j] zählt; und
   (e2) Ermitteln des jeweiligen für die Burrows-Wheeler-Rücktransformation benötigten Ranges rank(i) an der Position i mittels des entsprechenden ermittelten relativen Ranges r[i] und des entsprechenden abgespeicherten Häufigkeitsparameters b[j,x].

9. Verfahren nach Anspruch 8,
   **dadurch gekennzeichnet,**
   **dass** der zweite Zähler an einer ersten Zählposition j· L, falls sich die entsprechende Position i in einer ersten Blockhälfte B[j·L,...,j·L+L/2-1] befindet, oder an einer zweiten Zählposition (j+1)·L, falls sich die entsprechende Position i in einer zweiten Blockhälfte B[j·L+L/2,...,(j+1)·L-1] befindet, zur Ermittlung des relative Ranges r[i] zu zählen beginnt.

10. Verfahren nach Anspruch 7 oder 9,
    **dadurch gekennzeichnet,**
    **dass** sich der für die Burrows-Wheeler-Rücktransformation benötigte Rang rank(i) an der Position i aus der Beziehung

$$rank\,[i] = \begin{cases} b\,[i\,/\,L - 1, x] + r\,[i] & falls & i \bmod L < L\,/\,2 \\ b\,[i\,/\,L, x] - r\,[i] - 1 & sonst \end{cases}$$

ergibt.

## Claims

1. Method for carrying out an inverse Burrows-Wheeler transform with efficient use of memory, in which there is an inverse transform of a string S with a predetermined string length n, said string having a multiplicity of symbols x of a predetermined alphabet A, wherein a rank rank(i) at a position i, where $0 \le i < n$, of the string S specifies the frequency of the symbol x that is in the position i in a partial string S[0, ..., i] of the string S, **characterized by** the following steps:

   (a) subdividing the string S into a number n' of blocks B with a predetermined block size L, where in each case the j-th Block B[j], where $0 \le j < n'$, starts at the position j · L;
   (b) determining respectively one frequency parameter b[j,x] for each symbol x and each block B[j], where the respective frequency parameter b[j,x] specifies the frequency of the symbol x that is in the corresponding position i up to the corresponding j-th block B[j];
   (c) storing the respectively determined frequency parameter b[j,x];
   (d) respectively ascertaining a relative rank r[i] for each position i of the string S, wherein the relative rank r[i] specifies the frequency of the symbol x that is in the respective position i exclusively in the corresponding j-th block B[j], which contains the corresponding position i, up to the position i; and
   (e) ascertaining the respective rank rank(i) required for the inverse Burrows-Wheeler transform at the position i by means of the corresponding ascertained relative rank r[i] and the corresponding stored frequency parameter b[j,x].

2. Method according to Claim 1, **characterized**

in that the number n' of blocks B[j] emerges from the relationship $n' = \left\lceil \dfrac{n}{L} \right\rceil.$

3. Method according to one or more of the preceding claims, **characterized**
in that each symbol x of the predetermined alphabet A has a predetermined symbol length.

4. Method according to one or more of the preceding claims, **characterized**
in that the rank rank(i) at the position i, which is required for the inverse Burrows-Wheeler transform according to method step (e), emerges from the relationship rank[i] = b[i/L-1,x]+r[i] .

5. Method according to one or more of Claims 1 to 3, **characterized**
in that method steps (d) and (e) a carried out by means of the following partial method steps:

(d1) respectively calculating the relative rank r[i] for each position (i) of the string S from the rank rank(i) of the symbol x at the corresponding position i and the corresponding stored frequency parameter b[j,x] for the symbol x and the corresponding j-th block B[j], where the relative rank r[i] specifies the frequency of the symbol x that is in the respective position i exclusively in the corresponding j-th block B[j], which contains the corresponding position i;
(d1') storing the respectively calculated relative rank r[i]; and
(e1) ascertaining the respective rank rank(i) required for the inverse Burrows-Wheeler transform at the position i by means of the corresponding stored relative rank r[i] and the corresponding stored frequency parameter b[j,x].

6. Method according to Claim 5, **characterized**
in that, for the calculation of the relative rank r[i], the rank rank(i) is ascertained by means of a first counter, which counts the frequency of the symbol x at the corresponding position i in the partial string S[0, ..., i].

7. Method according to Claim 6, **characterized in that** the relative rank r[i] emerges from the relationship

$$r[i] = \begin{cases} rank[i] - b[i/L - 1, x] & if & i \bmod L < L/2 \\ b[i/L, x] - rank[i] - 1 & otherwise \end{cases}.$$

8. Method according to one or more of Claims 1 to 3, **characterized**
in that method steps (d) and (e) are carried out by means of the following partial method steps:

(d2) ascertaining the relative rank r[i] by means of a second counter, which counts the frequency of the symbol x at the corresponding position i exclusively in the corresponding j-th block B[j]; and
(e2) ascertaining the respective rank rank(i) required for the inverse Burrows-Wheeler transform at the position i by means of the corresponding ascertained relative rank r[i] and the corresponding stored frequency parameter b[j,x].

9. Method according to Claim 8, **characterized**
in that, for the purposes of ascertaining the relative rank r[i], the second counter starts to count at a first count position j·L if the corresponding position i is situated in a first block half B[j·L, ..., j·L+L/2-1] or starts to count at a second count position (j+1)·L if the corresponding position i is situated in a second block half B[j·L+L/2, ..., (j+1) · L-1].

10. Method according to Claim 7 or 9, **characterized in that** the rank rank[i] required for the inverse Burrows-Wheeler transform at the position i emerges from the relationship

$$rank[i] = \begin{cases} b[i/L - 1, x] + r[i] & if \quad i \bmod L < L/2 \\ b[i/L, x] - r[i] - 1 & otherwise \end{cases}.$$

**Revendications**

1. Procédé pour l'exécution efficace en terme de mémoire d'une transformée inverse de burrows-wheeler, dans laquelle une chaîne S avec une longueur de chaîne n prédéterminée est transformée inverse, qui présente une pluralité de symboles x d'un alphabet A prédéterminé, dans lequel un rang rank(i) à une position i, avec $0 \leq i < n$ de la chaîne S indique la fréquence du symbole x étant à la position i dans une chaîne partielle S[0, ..., i] de la chaîne S, **caractérisé par** les étapes suivantes :

   (a) subdivision de la chaîne S en un nombre n' de blocs B avec une grandeur de bloc L prédéterminée, dans lequel respectivement le j$^{ième}$ bloc B[j] avec $0 \leq j < n'$, commence à la position j · L ;
   (b) détermination respectivement d'un paramètre de fréquence b[j, x] pour chaque symbole x et chaque bloc B[j], dans lequel le paramètre de fréquence b[j, x] respectif indique la fréquence du symbole x étant à la position i correspondante jusqu'au j$^{ième}$ bloc B[j] ;
   (c) mise en mémoire du paramètre de fréquence b[j, x] déterminé respectif ;
   (d) calcul respectivement d'un rang r[i] relatif, à chaque position i de la chaîne S, dans lequel le rang r[i] relatif indique la fréquence du symbole x étant à la position i correspondante dans le j$^{ième}$ bloc B[j] correspondant qui contient la position i, jusqu'à la position i correspondante ; et
   (e) calcul du rang rank(i) nécessaire pour la transformée inverse de burrows-wheeler à la position i au moyen du rang r[i] relatif calculé correspondant et du paramètre de fréquence b[j, x] enregistré correspondant.

2. Procédé selon la revendication 1, **caractérisé en ce que** le nombre n' des blocs B[j] dérive de la relation

   $$n' = \left\lceil \frac{n}{L} \right\rceil.$$

3. Procédé selon une ou plusieurs des revendications précédentes,
   **caractérisé en ce que**
   chaque symbole x de l'alphabet A prédéterminé présente une longueur de symbole prédéterminée.

4. Procédé selon une ou plusieurs des revendications précédentes,
   **caractérisé en ce que**
   le rang rank(i) nécessaire pour la transformée inverse de burrows-wheeler selon l'étape de procédé (e) à la position i dérive de la relation *rank[i]-b[i/L - 1,x] + r[i]*.

5. Procédé selon une ou plusieurs des revendications 1 à 3,
   **caractérisé en ce que**
   les étapes de procédé (d) et (e) sont exécutées au moyen des étapes de procédé suivantes :

   (d1) calcul respectivement du rang r[i] relatif à chaque position (i) de la chaîne S à partir du rang rank i du symbole x à la position correspondante i et du paramètre de fréquence b[j, x] correspondant enregistré pour le symbole x et le j$^{ième}$ bloc B[j] correspondant, dans lequel le rang r[i] relatif indique la fréquence du symbole x étant à la position i respective exclusivement dans le j$^{ième}$ bloc B[j] qui contient la position i correspondante ;
   (d1') enregistrement du rang r[i] relatif calculé respectif ; et
   (e1) calcul du rang rank(i) nécessaire pour la transformée inverse de burrows-wheeler à la position i au moyen du rang r[i] relatif calculé correspondant et du paramètre de fréquence b[j, x] enregistré correspondant.

6. Procédé selon la revendication 5,
   **caractérisé en ce que**
   le rang rank (i) pour le calcul du rang r[i] relatif est calculé au moyen d'un premier numérateur qui compte la fréquence du symbole x à la position i correspondante dans la chaîne partielle S[0, ..., i].

7. Procédé selon la revendication 6,

**EP 1 924 931 B1**

**caractérisé en ce que** le rang r[i] relatif dérive de la relation

$$r[i] = \begin{cases} rank\,[i] - b[i/L-1,x] \\ b[i/L,x] - rank\,[i] - 1 \end{cases}$$ si $i \bmod L < L/2$ sinon.

8. Procédé selon une ou plusieurs des revendications 1 à 3,
**caractérisé en ce que**
les étapes de procédé (d) et (e) sont exécutées au moyen des étapes de procédé suivantes :

(d2) calcul du rang r[i] relatif au moyen d'un deuxième numérateur qui compte la fréquence du symbole x à la position i correspondante uniquement dans le j$^{ième}$ bloc B[j] ; et
(e2) calcul du rang rank(i) nécessaire pour la transformée inverse de burrows-wheeler à la position i au moyen du rang r[i] relatif calculé correspondant et du paramètre de fréquence b[j, x] enregistré correspondant.

9. Procédé selon la revendication 8,
**caractérisé en ce que**
le deuxième numérateur se trouve à une première position de numération j·L, au cas où la position correspondante i se trouve dans une première moitié de bloc B[j·L, ..., j·L+L/2-1] ou à une deuxième position de numération (j+1)·L, au cas où la position correspondante i se trouve dans une deuxième moitié de bloc B[j·L+L/2, ..., (j+1)·L-1], pour calculer le rang r[i] relatif.

10. Procédé selon la revendication 7 ou 9,
**caractérisé en ce que** le rang rank(i) nécessaire pour la transformée inverse de burrows-wheeler à la position i est dérivé à partir de la relation
rank

$$[i] = \begin{cases} b[i/L-1,x] + r[i] \\ b[i/L,x] - r[i] - 1 \end{cases}$$ si sinon $i \bmod L < L/2$

FIG 1

FIG 2

# FIG 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **BURROWS, M. ; WHEELER, D.J.** A block-sorting lossless data compression algorithm. *SRC Research Report,* 1994, http:// gatekeeper.resarch.compaq.com/pub/DEC/SRC/researchreports/Abstracts/src-rr-124.html

- Space-time tradeoffs in the Inverse B-W Transform. **SEWARD J.** PROCEEDINGS OF THE 2001 DATA COMPRESSION CONFERENCE (DCC 2001). IEEE, 27. Marz 2001, 439-448